# EUROPEAN PATENT SPECIFICATION

(11) **EP 0 580 919 B1**
(45) Date of publication and mention of the grant of the patent: **06.12.1995**
(21) Application number: 92830418.7
(22) Date of filing: 28.07.1992
(51) Int. Cl.: H02M 3/156

(54) **Frequency modulated switching power supply**
Frequenzmodulierter Schaltnetzteil
Alimentateur à découpage avec modulation de fréquence

(43) Date of publication of application: 02.02.1994
(73) Proprietor: SGS-THOMSON MICROELECTRONICS s.r.l., 20041 Agrate Brianza (Milano) (IT)
(72) Inventor: Ferrario, Bruno, I-22073 Fino Mornasco (IT)
(74) Representative: Pellegri, Alberto

(56) References cited:
- EP-A- 0 223 315
- WO-A-85/01400
- US-A- 3 946 330

## Description

The present invention relates to a switching power supply circuit for direct connection to an AC power outlet and more in general to a frequency modulator circuit which is particularly suited for modulating the switching frequency of a power supply in function of the instantaneous value of a rectified AC voltage.

The so-called switching type power supplies are widely used circuits in electronic and electromechanical appliances for providing a low-voltage DC supply of electronic circuits through a rectifier circuit which may be directly connected to the AC power outlet without using a step-down transformer. The absence of a transformer and the mode of operation of a switching-type power supply circuit causes the generation of electromagnetic disturbances which propagate through the AC power distribution network. The main frequency of these disturbances which is related to the switching frequency of the power supply circuit may have a value which interferes with telecommunication systems using the power distribution lines as signal path and may also cause problems in other electronic apparatuses, connected to the AC power distribution network.

WO-A-85/01400 discloses a power supply incorporating a driving oscillator circuit (SRCC) that monitors the DC voltage across the load and adjust the oscillator frequency accordingly to regulate the voltage according to the load requirements. In an alternative embodiment, the pulse width is kept constant and only the pulse frequency is varied, the number of pulses delivered during the initial portion of the full wave of the rectified voltage being larger and decreasing in inversed proportion to the amplitude of the rectified full wave. Therefore the power delivered to the load may be altered by altering the total number of pulses within each full wave cycle.

Commonly the oscillator employed for determining a certain oscillation frequency of a switching-type power supply circuit, i.e. for driving a power switch of the circuit, comprises a ramp generating circuit, the output ramp signal of which is fed to an input of a comparator. To another input of the comparator a reference voltage is applied in order to determine a certain triggering threshold of the comparator, which drives the charge and discharge switches of a capacitance of the ramp generator. The oscillation frequency is normally pre-established by selecting a value of capacitance and/or resistance suitable to determine a certain RC characteristic for the charge and discharge processes. Moreover, the ramp generator circuit commonly utilizes a constant current generator, that may be composed of a buffer capable of forcing a certain constant current through a resistance. The constant current so generated is mirrored in a charge/discharge network of the capacitor of the ramp generator circuit.

It has now been found and is an object of the present invention, that by "modulating" the oscillation frequency so as to have an instantaneous frequency value which is inversely proportional to the instantaneous amplitude of the rectified RC voltage (i.e. a low frequency of oscillation when the instantaneous value of the rectified AC voltage is high and therefore also the current which flows through the power switch is high and viceversa) has a decisive effect in attaining two important results. Firstly, by reducing the oscillation frequency when conditions of high switching current persist, the energy associated with electromagnetic disturbances which are transmitted through the AC power distribution network is greatly reduced. Secondly, a reduction of the oscillation frequency when the switching current is relatively high reduces power losses through the power switch. In other words, by reducing the switching frequency when conditions of a high switching current persist, a net improvement of the performance of the power supply circuit and an attenuation of the noise produced are obtained.

In accordance with a preferred embodiment of the present invention, the modulation of the oscillation frequency, in function of the instantaneous value of the rectified AC voltage, of an oscillator circuit comprising a voltage ramp generator, takes place by employing a divider circuit having two inputs and an output. To a first input thereof, a signal representative of the intantaneous AC voltage, e.g. of the AC voltage as recified by a normal bridge rectifier, is applied. To the other input of the divider circuit a voltage representative of the RMS value of the rectified AC voltage, as easily obtained on the output node of a low-pass filter which may be connected across the output nodes of the bridge rectifier, is applied. As it is well known, a so-called divider is a circuit capable of generating through an output node a current given by: I_{OUT} = K(|Vᵢₛₜ|/V_{RMS}). This output current (I_{OUT}) generated by the divider circuit is utilized for modulating the oscillation frequency of the oscillator and has an instantaneous value which is proportional to the instantaneous value of the rectified AC voltage (Vᵢₛₜ), "normalized" as referred to its RMS value (V_{RMS}). Therefore, the value of the output current I_{OUT} advantageously depends only on the design parameters of the circuit and is independent of the actual RMS value of the AC voltage, which notably may vary from country to country. The output node of the frequency modulating circuit (i.e. of the divider circuit) may be directly connected to the resistance used in the current generator circuit of the ramp generator circuit of the oscillator, in order to substract from the charge/discharge current of the capacitance of the ramp generator a variable current (I_{OUT}) generated by the modulating circuit in function of the instantaneous value of the rectified AC voltage.

The different aspects and advantages of the invention will become more evident through the description of an embodiment thereof and by referring to the annexed drawing which reproduces a functional circuit diagram of a modulator circuit object of the present invention coupled to a voltage ramp oscillator which is commonly used in switching power supplies.

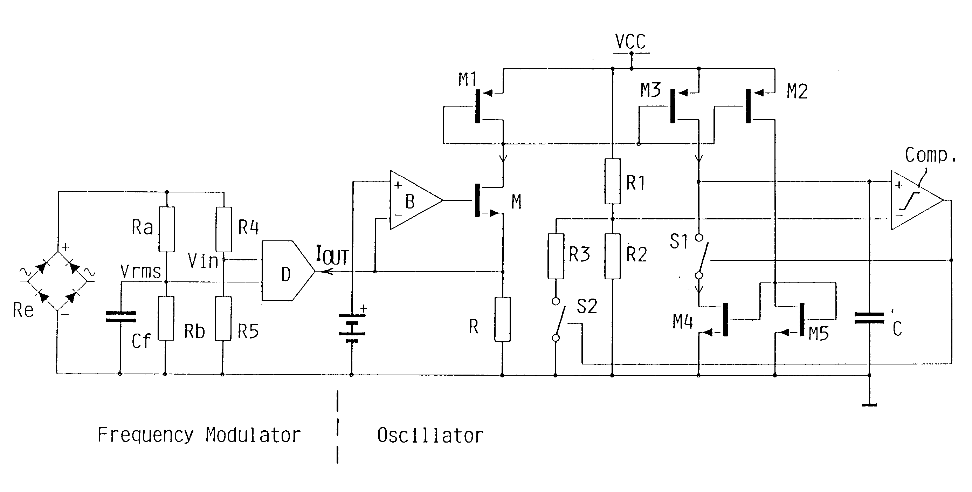

With reference to the figure, a typical oscillating circuit (OSCILLATOR) commonly used in switching-type power supplies, is composed of a voltage ramp generating circuit and a comparator COMP, the triggering threshold of which may be established by means of a voltage divider formed by R1 and R2. The ramp generator circuit comprises a capacitance C, which may be charged by the current delivered by the transistor M3 and discharged through a discharge path, controlled by a switch S1 driven by the comparator COMP, by the current delivered by the transistor M4. The frequency of oscillation may be adjusted by establishing a certain charge and discharge current of the capacitance C and this is commonly achieved by utilizing a constant current generator which, as shown, may be composed of a buffer B capable of controlling a transistor M, which forces a certain current through a resistance R, the value of which may be chosen in function of the desired frequency of oscillation. Such a pre-defined current is mirrored through the transistors M1, M2 and M5 on the charge and discharge transistors M3 and M4 of the capacitance C, respectively. A second switch, S2, driven by the comparator COMP, has the purpose of connecting R3 in parallel with R2 in order to lower the triggering threshold of the comparator COMP to a certain level of the voltage ramp.

According to a preferred embodiment of the invention, the frequency of oscillation so pre-defined, is modulated in function of the instantaneous value of the rectified AC voltage by employing a frequency modulating circuit (FREQUENCY MODULATOR) composed essentially of a divider circuit, D, having two inputs. A first input (Vᵢₙ) is connected to an intermediate node of a voltage divider formed by the resistances R4 and R5, which is connected across the output nodes of a bridge rectifier, Re, which may be directly connected to the AC outlet. A second input is connected to the output node (V_{RMS}) of a low-pass filter, formed by the network which comprises Ra, Rb and Cf, connected across the output nodes of the bridge rectifier Re. The divider circuit D produces on its output node, an output current which is given by: I_{OUT} = K(|Vᵢₙ|/V_{RMS}), where Vᵢₙ is a signal having the same wave form of the rectified AC voltage and V_{RMS} is a voltage representative of the RMS value of the AC voltage.

The current I_{OUT} produced by the frequency modulator circuit is subtracted to said pre-established charge/discharge current of the capacitance C and therefore, "modulates" the frequency of oscillation between a maximum value (which will correspond to the nominal frequency of oscillation as established by the design of the oscillator circuit) and a minimum value which may be also easily pre-defined and which is reached in coincidence with peak values of the modulating current I_{OUT} produced by the frequency modulator circuit. Therefore, the frequency of oscillation will be variable and notably inversely proportional to the instantaneous value of the rectified AC voltage as normalized in respect to its RMS value.

In this way, the modulating current I_{OUT} produced by the frequency modulator circuit of the invention will have a value which depends exclusively from circuital design parameters and not by the actual RMS value of the AC voltage. Therefore, the switching power supply having a modulated frequency in accordance with the present invention, may be used in different locations also having different AC power distribution standards (e.g. European countries and United States) without any alteration of performance.

Beside the above noted advantages of attenuating the disturbances which are produced by a switching power supply circuit on the AC network and of reducing power losses, the circuit of the invention may be easily "retrofitted" to an existing oscillator circuit, without the need of redesigning the oscillator circuit. The maximum frequency of oscillation may remain the same as determined by an existing oscillator circuit, while the minimum frequency of oscillation, which is achieved by means of the modulating circuit of the invention, will depend exclusively by circuit design parameters and therefore may be easily pre-determined according to need.

## Claims

1. A switching-type power supply for direct connection to an AC power distribution network, comprising a voltage ramp type oscillator (OSCILLATOR), the frequency of oscillation of which is determined by a charge current and a discharge current of a capacitance (C), and a circuit capable of varying said charge and discharge currents in an inversely proportional relationship with the instantaneous amplitude of a rectified AC voltage, thus modulating said oscillation frequency in an inversely proportional relationship with the instantaneous amplitude of the rectified AC voltage of said distribution network, characterized in that said circuit comprises a divider circuit (D) having a first and a second input and an output, the first input being connected to the output node of a low-pass filter (Cf, Ra, Rb) connected in cascade to a rectifier circuit (Re) of said AC voltage, the second input being connected to an intermediate node of a voltage divider (R4, R5) functionally connected to the output of said rectifier circuit (Re) and the output node being functionally connected to the output node of a generator (B, M0/, R, M1, M2, M3, M4, M5) of said charge and discharge currents;
said circuit (D) producing through said output a current proportional to a signal representative of the instantaneous value (Vin) of the rectified AC voltage, present on said first input, divided by a voltage (Vrms) representative of an RMS value of said AC voltage present on said second input.

## Patentansprüche

1. Schaltende Spannungsversorgung für den direkten Anschluß an ein Wechselspannungsnetz, umfassend einen Spannungsrampen-Oszillator (OSZILLATOR) dessen Schwingungsfrequenz bestimmt wird durch einen Ladestrom und einen Entladestrom einer Kapazität (C), und eine Schaltung, die in der Lage ist, die Lade- und Entladeströme in einer zueinander umgekehrt proportionalen Weise mit der augenblicklichen Amplitude einer gleichgerichteten Wechselspannung zu variieren, um auf diese Weise die Schwingungsfrequenz in umgekehrt proportionalem Verhältnis zu der Augenblicksamplitude der gleichgerichteten Wechselspannung des Netzwerks zu modulieren, dadurch gekennzeichnet, daß die Schaltung aufweist: eine Teilerschaltung (D) mit einem ersten und einem zweiten Eingang und einem Ausgang, von denen der erste Eingang an den Ausgangsknoten eines Tiefpaßfilters (Cf, Ra, Rb) angeschlossen ist, das in Kaskade zu einer Gleichrichterschaltung (Re) für die Wechselspannung geschaltet ist, der zweite Eingang an einen Zwischenknoten eines Spannungsteilers (R4, R5) angeschlossen ist, der funktionell an den Ausgang der Gleichrichterschaltung (Re) angeschlossen ist, und der Ausgangsknoten funktionell an den Ausgangsknoten eines Generators (B, M0/, R, M1, M2, M3, M4, M5) für die Lade- und Entladeströme angeschlossen ist; und daß
die Schaltung (D) über den Ausgang einen Strom erzeugt, der proportional ist zu einem Signal, welches repräsentativ ist für den Momentanwert (Vin) der gleichgerichteten Wechselspannung am ersten Eingang, geteilt durch eine Spannung (Vrms), die kennzeichnend ist für einen Durchschnittswert der Spannung an dem zweiten Eingang.

## Revendications

1. Alimentation de puissance de type à découpage destinée à être connectée directement à un réseau de distribution alternative comprenant un oscillateur de type à rampe de tension (OSCILLATOR) dont la fréquence d'oscillation est déterminée par un courant de charge et un courant de décharge d'une capacité (C), et un circuit capable de faire varier les courants de charge et de décharge selon une relation inversement proportionnelle à l'amplitude instantanée d'une tension alternative redressée, modulant ainsi la fréquence d'oscillation de façon inversement proportionnelle à l'amplitude instantanée de la tension alternative redressée du réseau de distribution, caractérisée en ce que ledit circuit comprend un circuit diviseur (D) ayant une première et une seconde entrée et une sortie, la première entrée étant connectée au noeud de sortie d'un filtre passe-bas (Cf, Ra, Rb) connecté en cascade avec un circuit redresseur (Re) de ladite tension alternative, la seconde entrée étant connectée à un noeud intermédiaire d'un diviseur de tension (R4, R5) fonctionnellement connecté à la sortie du circuit redresseur (Re) et le noeud de sortie étant fonctionnellement connecté au noeud de sortie d'un générateur (B, M0/, R, M1, M2, M3, M4, M5) desdits courants de charge et de décharge ;
ledit circuit (D) produisant, par l'intermédiaire de ladite sortie, un courant proportionnel à un signal représentatif de la valeur instantanée (Vin) de la tension alternative redressée présente sur la première entrée divisée par une tension (Vrms) représentative d'une valeur efficace de la tension alternative présente sur la seconde entrée.
